# EUROPÄISCHE PATENTSCHRIFT

(11) **EP 2 736 062 B1**
(45) Veröffentlichungstag und Bekanntmachung des Hinweises auf die Patenterteilung: **17.05.2017**
(21) Anmeldenummer: 13005496.8
(22) Anmeldetag: 26.11.2013
(51) Int. Cl.: H01H 36/00, H04L 25/02, H05K 7/14, H01R 9/26, G05B 19/05

(54) **Modulares Steuerungssystem**
Modular control system
Système de commande modulaire

(30) Priorität: 26.11.2012 DE 102012023069
(43) Veröffentlichungstag der Anmeldung: 28.05.2014
(73) Patentinhaber: TQ-Systems GmbH, 82229 Seefeld (DE)
(72) Erfinder: Kloyer, Gottfried, 82226 Buch/Ammersee (DE); Wolters, Ralf, 82205 Gilching (DE); Denk, Frank, 88074 Meckenbeuren (DE); Trepte, Johannes, 82229 Seefeld (DE)
(74) Vertreter: Grättinger Möhring von Poschinger Patentanwälte Partnerschaft

(56) Entgegenhaltungen:
- DE-A1- 19 710 768
- DE-A1-102009 056 563
- DE-B3-102011 110 183
- US-A1- 2007 120 574
- Anonymous: "PSSuniversal - Programmable control systems PSS - System Description - No. 21256-EN-04", , 1. Oktober 2010 (2010-10-01), Seiten 1-89, XP055041267, Gefunden im Internet: URL:http://www.pilz.com/downloads/open/PSS universal_Sys_Descr_21256-EN-04.pdf [gefunden am 2012-10-17]

## Beschreibung

Die vorliegende Erfindung betrifft ein modulares Steuerungssystem, nämlich eine speicherprogrammierbare Steuerung, umfassend eine Mehrzahl an zum Anbau an eine Tragschiene, insbesondere eine Hutschiene, geeigneten Steuerungsmodulen, wobei die Steuerungsmodule über ein Bussystem miteinander verbunden sind und Anschlusselemente zum Anschluss externer Feldelemente aufweisen.

Derartige speicherprogrammierbare Steuerungssysteme, die in Modulbauweise eine Mehrzahl an auf geeignete Weise miteinander zu verbindenden Steuerungsmodulen aufweisen und durch Hinzufügung weiterer Steuerungsmodule einfach erweiterbar sind, sind aus dem Stand der Technik hinlänglich bekannt. Sie werden zumeist an Tragschienen von Schaltschränken, Sicherungskästen oder dergleichen angebaut.

Unter einer speicherprogrammierbaren Steuerung (SPS; englisch: Programmable Logic Controller - PLC) wird dabei ein programmierbares System verstanden, welches zur Steuerung und/oder Regelung von externen Aktoren, Geräten, Anlagen oder dergleichen dient, die als externe Feldelemente daran angeschlossen werden. Bei einem solchen System können als externe Feldelemente in der Regel auch Sensoren oder Datenausgänge eines zu steuernden oder sonstigen Feldelements angeschlossen werden, um deren Signale im Rahmen der Steuerung/Regelung eines externen Feldelements zu berücksichtigen. Jedes Steuerungsmodul ist insoweit als I/O-Modul (Input/Output-Modul) mit Schnittstellen, nämlich den Anschlusselementen für externe Feldelemente, zur Datenein- und -ausgabe eingerichtet.

Neuartige Steuerungssysteme der vorstehend genannten Art sind häufig auch zur Ausgabe geeignet aufbereiteter Daten (z.B. Daten zum Zustand des Steuerungssystems oder der daran angeschlossenen Feldelemente) ausgestattet, wozu diese Daten über (wenigstens) eine geeignete Datenkommunikationsschnittstelle, z.B. eine Netzwerkschnittstelle zur drahtlosen oder drahtgebundenen Kommunikation, an ein externes Datenverarbeitungsgerät ausgegeben bzw. von diesem abgefragt werden können. Häufig findet dabei die Datenaufbereitung und -ausgabe über ein Hauptsteuerungsmodul statt, welches mit den weiteren Steuerungsmodulen des Systems bzw. mit deren Steuerungselektronik über das die verschiedenen Steuerungsmodule verbindende Bussystem kommunizieren kann. Über die - z.B. an einem Hauptsteuerungsmodul vorgesehene - Datenkommunikationsschnittstelle und das Bussystem kann vorteilhaft auch eine Steuerung bzw. Programmierung der Steuerungselektronik der einzelnen Steuerungsmodule erfolgen. Im Stand der Technik sind hierbei häufig die Steuerungselektronik sowie der Bussystemanschluss bzw. die Bussystemanbindung der einzelnen Steuerungsmodule auf derselben Platine angeordnet, also integral ausgestaltet.

Um eine einfache Montage und Erweiterbarkeit eines modularen Steuerungssystems der vorstehend beschriebenen Art zu gewährleisten, sind aus dem Stand der Technik bereits verschiedene Systemgestaltungen bekannt, bei denen die einzelnen Steuerungsmodule einander unmittelbar benachbart in der Tragschiene (z.B. eine Hutschiene, die häufig auch als DIN-Rail bezeichnet wird) montiert und - zur Herstellung der Stromversorgung für die einzelnen Steuerungsmodule und zu deren Anbindung an das Bussystem - auf geeignete Weise, z.B. mittels entsprechender Kabel, miteinander verbunden werden.

Als nachteilig erweist sich im Stand der Technik jedoch häufig, dass bei einem Defekt eines Steuerungsmoduls - z.B. einer Beschädigung der Steuerungselektronik des Moduls - stets das gesamte Steuerungsmodul bzw. dessen gesamte, die Bussystemanbindung beinhaltende Elektronik ausgetauscht werden muss. Zum Austausch eines Steuerungsmoduls müssen dabei regelmäßig auch die daran angeschlossenen Feldelemente abgeklemmt bzw. abgekoppelt und mit dem neuen Modul erneut verbunden werden; zudem ist bei entsprechenden Systemen während des Austausches eines Steuerungsmoduls in der Regel das gesamte System bzw. zumindest ein Teil des übrigen Systems lahmgelegt, da bei den aus dem Stand der Technik bekannten Systemgestaltungen durch Entfernung eines Steuerungsmoduls insbesondere die Bussystemarchitektur und ggfs. auch die zu anderen Steuerungsmodulen weiterführende elektrische Stromversorgung unterbrochen wird, jedenfalls sofern die Bussystemanbindung und die Stromversorgung der einzelnen Steuerungsmodule nicht über eine spezielle Montageschiene mit entsprechenden Anschlüssen für die einzelnen Module bereitgestellt wird.

Aus der DE 10 2011 110 183 B3 ist ferner ein gattungsgemäßes modulares System bekannt, bei welchem in Ergänzung zu den einleitend bereits genannten Merkmalen vorgesehen ist, dass die Steuerungsmodule jeweils einen an der Tragschiene montierbaren Grundkörper sowie einen lösbar an dem Grundkörper montierten Aufsatzkörper aufweisen, wobei der Grundkörper jedes Steuerungsmoduls einen Anschluss für die Stromversorgung des Steuerungsmoduls, wenigstens einen Bussystemanschluss zur Anbindung des Steuerungsmoduls an das Bussystem und wenigstens einen Anschluss für ein Feldelement aufweist und wobei der Aufsatzkörper jedes Steuerungsmoduls die Steuerungselektronik des jeweiligen Steuerungsmoduls aufweist. Bei diesem System ist jedoch - wie bei den weiteren z.B. aus den Druckschriften DE 10 2007 006 830 A1, DE 198 07 710 C2, DE 44 02 001 A1, DE 36 03 750 A1 und DE 197 10 768 A1 bekannten Geräten bzw. Systemen - keine Maßnahme beschrieben, wie das Bussystem auf besonders einfache Weise im letzten Steuerungsmodul eines gattungsgemäßen Systems terminiert werden könnte.

Vor diesem Hintergrund ist es die Aufgabe der vorliegenden Erfindung, ein modulares Steuerungssystem der gattungsgemäßen Art dahingehend weiterzubilden, dass sich dort eine Terminierung des Bussystems auf besonders einfache Art und Weise realisieren lässt. Ferner soll gewährleistet sein, dass sich dieses, z.B. bei einem Defekt der Steuerungselektronik eines Steuerungsmoduls, in besonders einfacher Weise warten bzw. reparieren lässt. Weitere Aspekte der vorliegenden Erfindung und ihrer bevorzugten Ausgestaltungen betreffen die Bereitstellung einer möglichst einfachen und fehlersicheren Erweiterbarkeit des Systems um weitere Steuerungsmodule sowie die möglichst einfache und fehlersichere Montage und Demontage der einzelnen Steuerungsmodule an bzw. von der Tragschiene.
Diese Aufgabe wird mit einem modularen Steuerungssystem nach Anspruch 1 gelöst, welches in Ergänzung zu den vorstehend bereits genannten gattungsgemäßen Merkmalen dadurch gekennzeichnet ist, dass der Grundkörper jedes Steuerungsmoduls einen Magnetschalter und ein Magnetelement aufweist, die derart angeordnet sind, dass der Magnetschalter eines ersten Steuerungsmoduls mit dem Magnetelement eines benachbart an der Tragschiene montierten Steuerungsmoduls zusammenwirkt, wobei der Magnetschalter im Falle der Abwesenheit eines Grundkörpers eines benachbarten Steuerungsmoduls das Bussystem durch Zuschaltung wenigstens eines Abschlusswiderstands terminiert und im Falle der Anwesenheit eines Grundkörpers eines benachbarten Steuerungsmoduls eine Anbindung des benachbarten Steuerungsmoduls an das Bussystem zulässt. Durch dieses Zusammenwirken von Magnetschalter und Magnetelement benachbarter Steuerungsmodule kann somit eine automatische Erkennung erfolgen, ob (auf der betreffenden Seite des Steuerungsmoduls) überhaupt ein unmittelbar benachbarter Grundkörper eines weiteren Steuerungsmoduls vorhanden ist, was vorliegend in besonders zweckmäßiger Weise zur automatisch erfolgenden Terminierung des Bussystems genutzt wird.

Dadurch dass im Rahmen der vorliegenden Erfindung der die Steuerungselektronik beinhaltende Aufsatzkörper lösbar mit dem Grundkörper des Steuerungsmoduls verbunden ist, kann - z.B. bei einem Defekt der Steuerungselektronik oder falls diese aus sonstigen Gründen ersetzt werden soll - zu Wartungs- bzw. Reparaturzwecken ausschließlich der Aufsatzkörper eines Steuerungsmoduls entfernt bzw. ausgetauscht werden, ohne dass hierfür der auf der Tragschiene montierte Grundkörper des betreffenden Steuerungsmoduls entfernt bzw. ausgetauscht werden muss. Ferner bedarf es dabei auch keiner Trennung des Grundkörpers von der externen elektrischen Stromversorgung und dem Bussystem und keiner Abkopplung der an entsprechenden Anschlusselementen des Grundkörpers angeschlossenen Feldelemente, so dass aufgrund der erfindungsgemäßen Systemgestaltung ein insgesamt sehr einfacher Austausch des die Steuerungselektronik beinhaltenden Anbaukörpers eines Steuerungsmoduls möglich ist.

Im Rahmen der vorliegenden Erfindung ist ersichtlich dafür Sorge zu tragen, dass beim Herstellen der (lösbaren) Verbindung zwischen dem Aufsatzkörper und dem Grundkörper eine geeignete Verbindung der Steuerelektronik mit der über den Grundkörper gegebenen Stromversorgung sowie eine Verbindung der Steuerelektronik mit dem am Grundkörper angeschlossenen Bussystem erfolgt, um die gewünschte Funktionalität des Steuerungsmoduls bereitstellen zu können.

Bei dem Bussystem, an welches die jeweiligen Steuerungsmodule grundkörperseitig angeschlossen sind, kann es sich um ein beliebiges (Feld-)Bussystem handeln, wobei in bevorzugter Weise ein 2-Draht-Bus oder ein 3-Draht-Bus, insbesondere ein CAN-Bussystem zur Verwendung kommt.

Ferner kann im Rahmen der vorliegenden Erfindung vorteilhaft vorgesehen sein, dass jedes Steuerungsmodul des Systems an seinem Grundkörper eine Mehrzahl an - als Dateneingänge und/oder Datenausgänge fungierenden - Anschlusselementen zum Anschluss externer Feldelemente aufweist, um mittels des betreffenden Steuerungsmoduls gleichzeitig eine Mehrzahl an externen Feldelementen steuern zu können und/oder um die Daten von einem oder mehreren Dateneingängen zum Zwecke der Steuerung/Regelung eines oder mehrerer Feldelemente berücksichtigen zu können. Die Anschlusselemente zum Anschluss der externen Feldelemente, über welche die Eingangs- und Ausgangssignale empfangen werden, sind bevorzugt in Form von handelsüblichen Feldklemmen mit "Push-In"-Technologie ausgestaltet, was einen besonders bequemen Anschluss der Feldelemente erlaubt.

In einer ersten bevorzugten Weiterbildung der Erfindung ist vorgesehen, dass die Steuerungsmodule zur einander unmittelbar benachbarten Montage an der Tragschiene eingerichtet sind, wobei ausschließlich ein erstes Steuerungsmodul (Hauptsteuerungsmodul) direkt mit der externen Stromversorgung zu verbinden ist und wobei alle Steuerungsmodule mittels geeignet zueinander korrespondierender Verbindungselemente, die an den Grundkörpern der jeweiligen Steuerungsmodule angeordnet sind, direkt mit dem wenigstens einen ihm unmittelbar benachbarten Steuerungsmodul derart verbunden sind, dass über die Verbindungselemente die Anbindung aller Steuerungsmodule an die Stromversorgung und an das Bussystem erfolgt. Mit anderen Worten wird somit sowohl die Stromversorgung als auch das Bussystem über die jeweiligen Verbindungselemente von Steuerungsmodul zu Steuerungsmodul durchgeschleift.

Dabei weist jedes Steuerungsmodul vorteilhaft zwei auf verschiedenen Seiten des Grundkörpers angeordnete Verbindungselemente auf, welche zur Herstellung der Bussystemanbindung und der Stromversorgung für alle Steuerungsmodule direkt mit dem hierzu jeweils korrespondierenden Verbindungselement eines benachbarten Steuerungsmoduls verbunden werden. Ein erstes der beiden Verbindungselemente dient damit vorteilhaft sowohl als Anschluss für die Stromversorgung als auch als Bussystemanschluss, während über das zweite Verbindungselement des jeweiligen Steuerungsmoduls die Stromversorgung des benachbarten Steuerungsmoduls sowie dessen Anbindung an das Bussystem erfolgt. Die Verbindungselemente können insbesondere als Steckverbinder realisiert sein.

Neben einer besonders kompakten Bauweise wird hierdurch der Montageaufwand eines erfindungsgemäßen Systems deutlich reduziert, da nach erfolgter Installation des Hauptsteuerungsmoduls, welches vorteilhaft auch die Hauptsteuerung für das Bussystem beinhaltet, jedes weitere Steuerungsmodul einfach unmittelbar benachbart zu einem bereits montierten Modul montiert und auf geeignete Weise - mittels der an den Grundkörpern der verschiedenen Module angeordneten Verbindungselemente - mit dem unmittelbar benachbarten Steuerungsmodul verbunden werden muss. Vorteilhaft kann dabei durch geeignete Gestaltung der Verbindungselemente vorgesehen sein, dass sich die - die Stromversorgung und das Bussystem betreffende - Verbindung benachbarter Steuerungsmodule bei bestimmungsgemäßer (d.h. unmittelbar benachbart zu einem bereits installierten Modul erfolgender) Montage des weiteren Steuerungsmoduls (bzw. seines Grundkörpers) automatisch herstellt.

In einer bevorzugten Weiterbildung der Erfindung kann vorgesehen sein, dass der Aufsatzkörper jedes Steuerungsmoduls mittels einer Steckverbindung am Grundkörper befestigt ist, was eine besonders einfache Demontage des Aufsatzkörpers vom Grundkörper ohne Werkzeugeinsatz erlaubt. Dabei kann bzw. muss vorgesehen sein, dass die in den Aufsatzkörper integrierte Steuerungselektronik auf geeignete Weise mit der - über den Grundkörper bereitgestellten - elektrischen Stromversorgung sowie dem - ebenfalls grundkörperseitig angeschlossenen - Bussystem kontaktiert wird. In besonders bevorzugter Weise kann dabei vorgesehen sein dass die den Aufsatzkörper am Grundkörper fixierende Steckverbindung gleichzeitig die hierfür notwendige Kontaktierung herstellt. Dies kann z.B. unter Verwendung einer Leiterplattensteckverbindung realisiert werden, z.B. indem die die Steuerelektronik tragende und fest im Aufsatzkörper verankerte Leiterplatte/Platine in einen grundkörperseitig angeordneten Leiterplattensteckverbinder eingesteckt wird. Gegebenenfalls kann dabei eine - wiederum vorteilhaft ohne Werkzeugeinsatz betätigbare - Sicherungs- bzw. Verriegelungseinrichtung vorgesehen sein, die in ihrer Verriegelungsstellung ein unbeabsichtigtes Lösen der Steckverbindung zwischen Grundkörper und Aufsatzkörper verhindert.

Im Rahmen einer weiteren bevorzugten Weiterbildung der Erfindung ist vorgesehen, dass die Verbindungselemente (sowie der Grundkörper und der Aufsatzkörper jedes Steuerungsmoduls) derart ausgestaltet sind, dass ein beliebiges Steuerungsmodul des Steuerungssystems ausgetauscht werden kann, ohne dass dabei eines der übrigen Steuerungsmodule ausgebaut oder verschoben werden muss. Dies stellt sicher, dass die Demontage bzw. der Austausch eines - möglicherweise zwischen zwei anderen Steuerungsmodulen installierten - Steuerungsmoduls mit geringst möglichem Aufwand erfolgen kann. Die zueinander korrespondierenden Verbindungselemente sind hierzu vorteilhaft so gestaltet, dass sich deren Verbindung durch eine vertikal zur Tragschiene verlaufende Bewegung herstellen und trennen lässt.

Vorteilhaft kann ferner vorgesehen sein, dass das Gehäuse des Grundkörpers und das Gehäuse des Aufsatzkörpers aller Steuerungsmodule (vorteilhaft inkl. des Hauptsteuerungsmoduls) sowie die am Grundkörper der jeweiligen Steuerungsmodule befindlichen Anschluss- und Verbindungselemente baugleich gestaltet sind, was die Herstellung eines erfindungsgemäßen Systems vereinfacht und die Produktionskosten senkt.

Wie bereits weiter oben erläutert kann im Rahmen der vorliegenden Erfindung in besonders bevorzugter Weise vorgesehen sein, dass die (grundkörperseitig erfolgende) Anbindung der Steuerungsmodule an die externe Stromversorgung und das Bussystem derart erfolgt, dass ein Aufsatzkörper eines beliebigen, nicht das Hauptsteuerungsmodul darstellenden Steuerungsmoduls ausgetauscht werden kann, ohne die Kommunikation der übrigen Steuerungsmodule über das Bussystem und deren Stromversorgung zu unterbrechen, womit der Austausch der Steuerungselektronik eines (oder mehrerer) Steuerungsmodule im laufenden Betrieb des Systems ermöglicht wird und ansonsten gegebene Stillstandszeiten vermieden werden. Soweit hierbei, wie weiter oben erläutert, die Stromversorgung und das Bussystem über zueinander korrespondierende Verbindungselemente durch die einzelnen Steuerungsmodule hindurchgeschleift wird, ist hierfür lediglich dafür Sorge zu tragen, dass die den Ein- und Ausgang für die Stromversorgung und die Bussystemverbindung bildenden Verbindungselemente der Steuerungsmodule jeweils derart innerhalb des Grundkörpers verschalten sind, dass die Stromversorgung und Bussystemanbindung der benachbarten Steuerungsmodule auch in Abwesenheit des Aufsatzkörpers (und der darin angeordneten Steuerungselektronik) gewährleistet ist.

Eine abermals bevorzugte Weiterbildung der Erfindung sieht vor, dass der Grundkörper jedes Steuerungsmoduls einen Verriegelungsmechanismus zur stabilen Befestigung des Grundkörpers an der Tragschiene aufweist, wobei der Verriegelungsmechanismus einen Bedienkörper aufweist, bei dessen Betätigung die Verriegelung des Grundkörpers an der Tragschiene gelöst und gleichzeitig der Grundkörper senkrecht zur Tragschiene von dieser angehoben wird. Hierdurch wird die (vollständige) Demontage eines Steuerungsmoduls von der Tragschiene erleichtert. Ferner kann hierdurch gewährleistet werden, dass die Trennung der Verbindungselemente eines zu demontierenden Steuerungsmoduls von denjenigen der benachbarten Steuerungsmodule durch eine exakt senkrecht zur Tragschiene erfolgende Bewegung des von der zu Tragschiene zu demontierenden Grundkörpers erfolgt. Dies verhindert eine ansonsten mögliche Verkantung des Grundkörpers bei dessen Demontage und eine hierdurch ggfs. erfolgende Beschädigung der Verbindungselemente.

Ferner kann dabei bevorzugt vorgesehen sein, dass der Bedienkörper ein Drehknopf ist und der Verriegelungsmechanismus eine mit dem Drehknopf gekoppelte Exzenterscheibe aufweist, die zur Spreizung von Haltebacken des Verriegelungsmechanismus dient, wobei ferner eine mit dem Drehknopf gekoppelte Anhebescheibe vorgesehen ist, die an ihrer zur Tragschiene weisenden Seite zwei sich über einen gewissen Winkelbereich der Anhebescheibe erstreckende Aufsätze mit in Drehrichtung zunehmender Höhe aufweist, die sich bei Betätigung des Drehknopfs an einem Rand der Tragschiene abstützen und mit fortschreitender Drehung ein vertikales Anheben des Grundkörpers von der Tragschiene bewirken.

Ersichtlich muss dabei durch geeignete Relativanordnung der Exzenterscheibe und der Anhebescheibe zweckmäßig dafür Sorge getragen sein, dass der Grundkörper bei zunehmender Drehung des Drehknopfs - durch geeignete Spreizung der Haltebacken durch die Exzenterscheibe - freigegeben wird, bevor die sich an je einem Rand der Hutschiene abstützenden Ansätze der Anhebescheibe den Grundkörper sukzessive von der Hutschiene abheben. Ferner kann die maximale Höhe der Ansätze so gewählt werden, dass die hierdurch - in vertikaler Richtung zur Tragschiene erfolgende - Anhebung des Grundkörpers von der Tragschiene zumindest so weit erfolgt, dass dabei die Verbindungselemente des Grundkörpers vollständig von den hierzu korrespondierenden Verbindungselementen der benachbarten Steuerungsmodule getrennt werden. Anhebescheibe und Exzenterscheibe können entweder als separate, jeweils mit dem Drehknopf verbundene Scheiben oder integral ausgestaltet sein.

Und schließlich kann im Rahmen der vorliegenden Erfindung noch vorgesehen sein, dass mittels separater und in die Grundkörper der jeweiligen Steuerungsmodule integrierter Schaltkreise, welche über geeignete Verbindungselemente untereinander und mit der Steuerungselektronik des jeweiligen Steuerungsmoduls verbunden sind, die exakte Einbauposition aller Steuerungsmodule relativ zu einem Hauptsteuerungsmodul des Steuerungssystems ermittelbar sind. Dabei ist von Vorteil, wenn die Verbindung der vorgenannten Schaltkreise der verschiedenen Steuerungsmodule über diejenigen Verbindungselemente realisiert ist, über die bereits die Stromversorgung und die Anbindung der Steuerungsmodule an das Bussystem erfolgt.

Nachfolgend wird ein Ausführungsbeispiel eines erfindungsgemäßen Systems anhand der Zeichnung näher erläutert. Dabei zeigt:
- Fig. 1: ein Ausführungsbeispiel eines erfindungsgemäßen modularen Steuerungssystems aus insgesamt drei auf einer Hutschiene montierten Steuerungsmodulen,
- Fig. 2: eine Darstellung eines Steuerungsmoduls mit vom Grundkörper gelösten Aufsatzkörper,
- Fig. 3: eine Explosionsdarstellung des Grundkörpers eines Steuerungsmoduls,
- Fig. 4A und 4B: zwei Darstellungen zur Veranschaulichung der Montage des Grundkörpers an der Tragschiene,
- Fig. 5: eine Darstellung der Unterseite eines Grundkörpers eines Steuerungsmoduls,
- Fig. 6: eine Explosionsdarstellung des Aufsatzkörpers eines Steuerungsmoduls und
- Fig. 7: eine schematische Darstellung eines Systems zur Erkennung des Einbauorts der verschiedenen Steuerungsmodule.

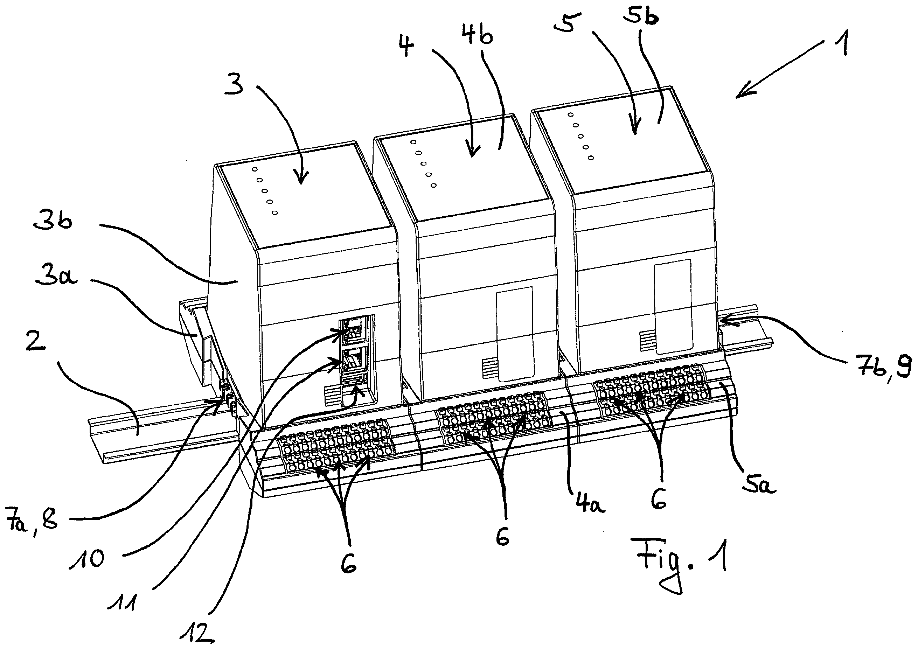

Fig. 1 zeigt ein Ausführungsbeispiel eines erfindungsgemäßen modularen Steuerungssystems 1 in Art einer speicherprogrammierbaren Steuerung aus insgesamt drei auf einer Hutschiene (DIN Rail) 2 unmittelbar benachbart zueinander montierten Steuerungsmodulen 3, 4, 5, welches rechtsseitig um weitere Steuerungsmodule erweitert werden kann. Jedes Steuerungsmodul 3, 4, 5 umfasst einen auf der Hutschiene 2 montierten Grundkörper 3a, 4a, 5a und einen lösbar an dem Grundkörper 3a, 4a, 5a befestigten Aufsatzkörper 3b, 4b, 5b.

Am Grundkörper 3a, 4a, 5a jedes Steuerungsmoduls 3, 4, 5 sind - auf zwei verschiedenen Seiten, von denen in Fig. 1 aus perspektivischen Gründen nur eine erkennbar ist - jeweils eine Mehrzahl an Anschlusselementen 6 zum Anschluss externer Feldelemente angeordnet, die vorliegend in Art von Blöcken mit je zwei Reihen zu je 12 Feldklemmen mit "Push-In"-Technologie ausgestaltet sind. Damit können an jedem Steuerungsmodul insgesamt 48 externe Feldelemente (z.B. zu steuernde Geräte oder Sensoren, deren Messwerte bei der Steuerung eines externen Feldelements zu berücksichtigen sind) angeschlossen werden.

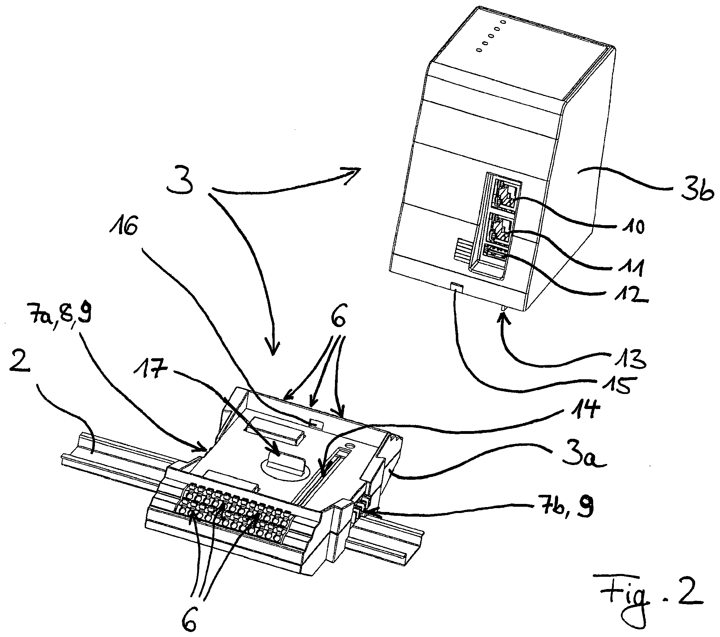

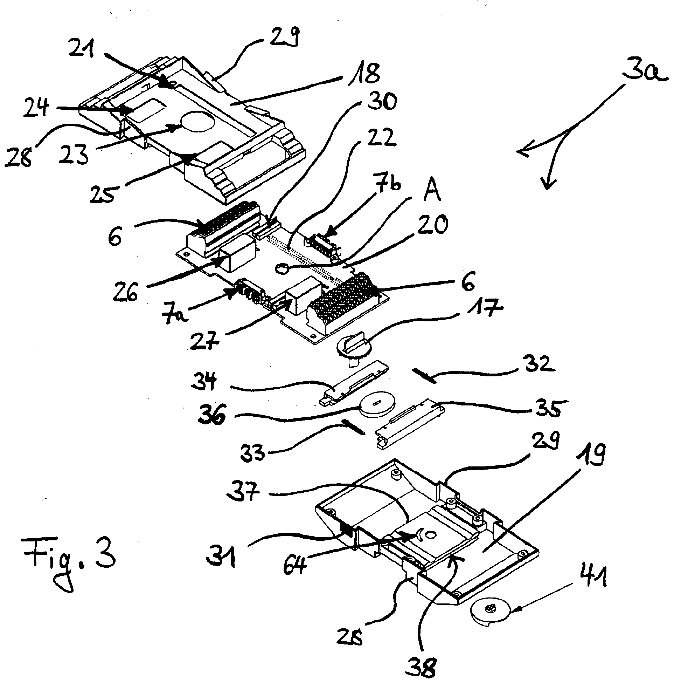

Ferner weist jedes Steuerungsmodul 3, 4, 5 zwei auf verschiedenen Seiten des Grundkörpers angeordnete Verbindungselemente 7a, 7b (vgl. hierzu auch Fig. 2 und Fig. 3) auf, die - sofern vorhanden - zum jeweils benachbarten Steuerungsmodul 3, 4, 5 weisen und als mehrpolige Steckverbinder zur Anbindung der verschiedenen Steuerungsmodule 3, 4, 5 an die externe Stromversorgung und das Bussystem dienen.

Dabei ist vorliegend vorgesehen, dass ausschließlich das in Fig. 1 links dargestellte Steuerungsmodul 3, welches als Hauptsteuerungsmodul des Steuerungssystems 1 dient, über das dort linksseitig angeordnete Verbindungselement 7a mit der externen Stromversorgung verbunden wird. Die weiteren Steuerungsmodule 4, 5 (und weitere am Steuerungsmodul 5 rechtsseitig ergänzbare Steuerungsmodule), sind dann über die die einzelnen Steuerungsmodule 3, 4, 5 verbindenden Verbindungselemente 7a, 7b, die hierzu jeweils innerhalb des jeweiligen Grundkörpers 3a, 4a, 5a geeignet verschalten sind, (indirekt) an die externe Stromversorgung angeschlossen, so dass vorliegend nicht jedes Steuerungsmodul 3, 4, 5 separat an die externe Stromversorgung anzuschlie-ßen ist. Die in Fig. 1 jeweils linksseitig angeordneten Verbindungselemente 7a dienen somit jeweils als Anschluss 8 für die Stromversorgung des betreffenden Steuerungsmoduls 3, 4, 5. Ferner ist gewährleistet, dass die Stromversorgung für alle Steuerungsmodule 3, 4, 5 bestehen bleibt, selbst wenn der Aufsatzkörper 3b, 4b, 5b eines beliebigen Steuerungsmoduls 3, 4, 5 z.B. zu Wartungszwecken vom Grundkörper gelöst wird.

Über die Verbindungselemente 7a, 7b erfolgt außerdem die Anbindung der einzelnen Steuerungsmodule 3, 4, 5 an das Bussystem. Dabei dienen jeweils die mit dem Verbindungselement 7a, 7b eines benachbarten Steuerungsmoduls verbundenen Verbindungselemente 7b, 7a auch als Bussystemanschluss 9 zur Anbindung des betreffenden Steuerungsmoduls 3, 4, 5 an das Bussystem, wobei vorliegend die Hauptsteuerung für das Bussystem in das Hauptsteuerungsmodul 3 integriert ist. Auch hierbei ist durch geeignete Verschaltung der Verbindungselemente 7a, 7b (bzw. der darin integrierten Bussystemanschlüsse 9) innerhalb der jeweiligen Grundkörper 4a, 5a dafür Sorge getragen, dass ein Aufsatzkörper 4b, 5b eines beliebigen Steuerungsmoduls 4, 5 (mit Ausnahme des die Steuerung für das Bussystem beinhaltenden Aufsatzkörpers 3b des Hauptsteuerungsmoduls 3) von dem betreffenden Grundkörper 4a, 5a gelöst bzw. abgekoppelt werden kann, ohne dass hierdurch die Kommunikation der übrigen Steuerungsmodule 3, 4, 5 über das Bussystem unterbrochen wird.

Das in Fig. 1 links dargestellte und als Hauptsteuerungsmodul fungierende Steuerungsmodul 3 verfügt ferner über drei Datenkommunikationsschnittstellen 10, 11, 12 in Form zweier LAN-Schnittstellen 10, 11 (RJ-45 Steckbuchsen) und eines USB-Anschlusses 12, welche mit der Steuerungselektronik (in Fig. 1 nicht erkennbar) des Steuerungsmoduls 3 gekoppelt sind und über welche das Steuerungssystem 1 mit einem Computernetzwerk bzw. einer externen Datenverarbeitungsanlage verbunden werden kann. Über besagte Schnittstellen (und das die Steuerungsmodule 3, 4, 5 verbindende Bussystem) können dann das Steuerungssystem 1 bzw. die einzelnen Steuerungsmodule 3, 4, 5 programmiert oder ausgelesen werden.

Die Grundkörper 3a, 4a, 5a und Aufsatzkörper 3b, 4b, 5b aller Steuerungsmodule 3, 4, 5 sind im Wesentlichen identisch aufgebaut, wobei sich die einzelnen Module z.B. hinsichtlich der darin verbauten Steuerungselektronik oder deren Funktionalität unterscheiden können. Darüber hinaus versteht sich von selbst, dass einzelne Steuerungsmodule eines erfindungsgemäßen Steuerungssystems ggfs. auch mittels eines - an die korrespondierenden Verbindungselemente 7b, 7a der Steuerungsmodule angeschlossenen - Verbindungskabels verbunden werden könne, was z.B. dann notwendig wird, wenn an einer ersten Hutschiene in einem Sicherungsschrank aus Platzgründen keine weiteren Steuerungsmodule mehr installiert werden können. Dann bietet es sich an, das Steuerungssystem durch Installation weiterer Steuerungsmodule an einer weiteren Hutschiene zu ergänzen, wobei das letzte Steuerungsmodul an der ersten Hutschiene über das Verbindungskabel mit dem ersten Steuerungsmodul an der zweiten Hutschiene verbunden wird.

Fig. 2 zeigt ein Steuerungsmodul 3 eines erfindungsgemäßen Steuerungssystems, bei welchem der Aufsatzkörper 3b von dem auf der Hutschiene 2 montierten Grundkörper 3a gelöst ist. Dabei ist zu erkennen, dass aus dem Aufsatzkörper 3b ein unterer Rand einer darin eingebauten Platine 13 hervorragt, welcher zur Herstellung einer Steckverbindung zwischen dem Grundkörper 3a und dem Aufsatzkörper 3b in einen hierzu korrespondierenden und entsprechend angeordneten Leiterplattensteckverbinder 14 eingesteckt werden kann. Diese Steckverbindung wird vorliegend durch eine Verriegelungseinrichtung umfassend (mindestens) eine am Ausatzkörper vorgesehene Haltenase 15, die in eine hierzu korrespondierende Aussparung 16 am Grundkörper 3a einhakt, gesichert. Die Verriegelungseinrichtung und die Steckverbindung können ohne Werkzeugeinsatz manuell gelöst werden. Ferner ist in Fig. 2 ein Bedienkörper 17 in Art eines Drehknopfs zu sehen, der nach Abnahme des Aufsatzkörpers 3b zugänglich ist und mit welchem die Verriegelung des Grundkörpers 3a an der Hutschiene 2 gelöst werden kann, wie dies weiter unten noch erläutert ist.

Fig. 3 zeigt eine Explosionsdarstellung des Grundkörpers 3a eines in einem erfindungsgemäßen Steuerungssystem einsetzbaren Steuerungsmoduls. Dieser umfasst zwei Gehäuseschalen 18, 19, eine innerhalb der Gehäuseschalen 18, 19 aufgenommene Leiterplatte 20 sowie einen - weiter unten noch näher erläuterten - Verriegelungsmechanismus zur Befestigung des Grundkörpers 3a an der Hutschiene.
Die obere Gehäuseschale 18 des Grundkörpers 3a weist eine spaltförmige Aussparung 21 auf, durch welche der aus dem Aufsatzkörper 3b herausreichende Rand der Platine 13 (vgl. Fig. 2) hindurchgeführt wird, um diesen zur Herstellung der Steckverbindung zwischen Grundkörper 3a und Aufsatzkörper 3b in den Leiterplattensteckverbinder 14 (vgl. Fig. 2) einzustecken. Der Leiterplattensteckverbinder 14 (vgl. Fig. 2) ist hierzu auf einem entsprechenden Bauplatz 22 der in den Grundkörper 3a verbauten Leiterplatte 20 montiert und stellt auf geeignete Weise die Anbindung der Steuerungselektronik an die Stromversorgung und das Bussystem sicher. Ferner weist die obere Gehäuseschale 18 des Grundkörpers 3a eine kreisförmige Aussparung 23 auf, durch welche - bei abgenommenen Aufsatzkörper 3b - der als Drehknopf ausgestaltete Bedienkörper 17 des Verriegelungsmechanismus' zugänglich und betätigbar ist. Außerdem sind zwei weitere rechteckige Aussparungen 24, 25 vorgesehen, durch welche zwei auf der Leiterplatte 20 des Grundkörpers montierte Relais 26, 27 zugänglich sind.
Auf der Leiterplatte 20 des Grundkörpers 3a sind ferner Verbindungselemente 7a, 7b angeordnet, welche mit je einem hierzu korrespondierenden Verbindungselement 7b, 7a eines unmittelbar benachbart an der Hutschiene montierten Steuerungsmoduls verbindbar sind. Bei den Verbindungselementen 7a, 7b handelt es sich vorliegend um 6-polige Verbindungsstecker mit Messerkontakten, die sich dadurch auszeichnen, dass die Verbindung zweier zueinander korrespondierender Verbindungselemente 7a, 7b durch eine vertikal zur Leiterplattenebene verlaufende Bewegung hergestellt bzw. getrennt werden kann.

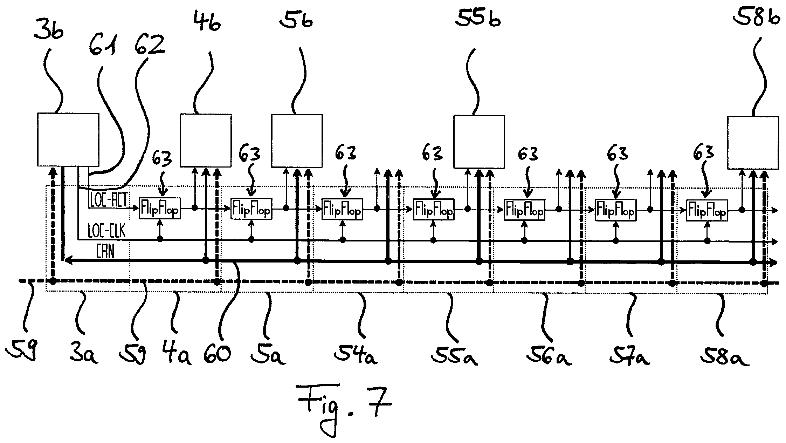

Vier Pole der jeweiligen Verbindungselemente 7a, 7b sind durch das Bussystem (vorliegend ein 2-Draht CAN-Bus) belegt. Die beiden weiteren Pole dienen der Verbindung der - weiter unten in Zusammenhang mit Fig. 7 erläuterten - Schaltkreise zur Erkennung der Einbauposition der verschiedenen Steuerungsmodule 3, 4, 5.

Die trapezförmigen Einbuchtungen 28 und Ausbuchtungen 29 an den Seiten der Gehäuseschalen 18, 19 dienen als Führungsmittel für die lagerechte Montage und Demontage der Steuerungsmodule 3, 4, 5 und gewährleisten in Art eines Schwalbenschwanz Nut-Feder-Systems, dass - bei der Montage eines Grundkörpers 3a, 4a, 5a benachbart zu einem bereits auf der Hutschiene 2 montierten Grundkörper 3a, 4a, 5a - die beiden Verbindungselemente 7a, 7b der benachbarten Grundkörper optimal zueinander positioniert und in exakt vertikaler Bewegungsrichtung einfach miteinander verbunden werden können.

Die der Spannungsversorgung und der Bussystemanbindung dienenden Kontakte der verschiedenen Verbindungselemente 7a, 7b, sind - auf der nicht dargestellten Unterseite der in den Grundkörper 3a integrierten Platine 20 - geeignet miteinander verschalten, um in dem bereits beschriebenen Sinn die Stromversorgung und Bussystemanbindung für alle Steuerungsmodule zu gewährleisten.
Auf der Platine 20 des Grundkörpers 3a sind randseitig ferner zwei als Magnetschalter fungierende Reed-Relais 30 angeordnet, die mit dem hierzu korrespondierend angeordneten Magnetelement 31 des Grundkörpers eines benachbarten Steuerungsmoduls zusammenwirken können, sofern ein solches auf der betreffenden Grundkörperseite montiert ist. Dabei ist vorliegend vorgesehen, dass die Magnetschalter 30 mit der Bussystemverbindung zwischen den Verbindungselementen 7a, 7b verschalten sind, um im Falle der Abwesenheit eines benachbarten Grundkörpers eines weiteren Steuerungsmoduls auf der betreffenden Seite das Bussystem durch Zuschaltung wenigstens eines (nicht dargestellten) Abschlusswiderstands zu terminieren oder im Falle der Anwesenheit eines benachbarten Grundkörpers eines weiteren Steuerungsmoduls auf der betreffenden Seite dessen Anbindung an das Bussystem zuzulassen. Vorliegend schaltet jedes Reed Relay - bei Abwesenheit eines benachbarten Grundkörpers - einen Abschlusswiderstand von 60 Ohm zu, so dass das Bussystem in üblicher Weise mit einem Widerstand von 120 Ohm terminiert wird.

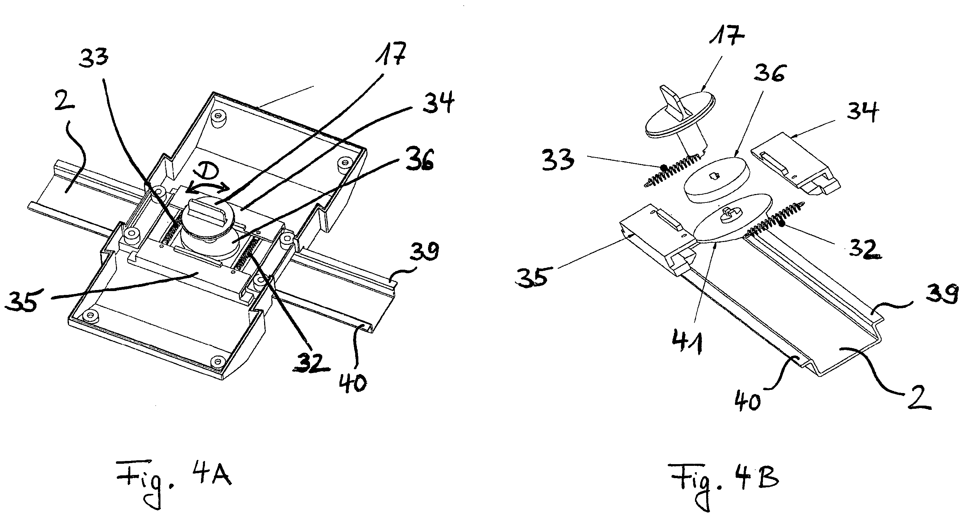

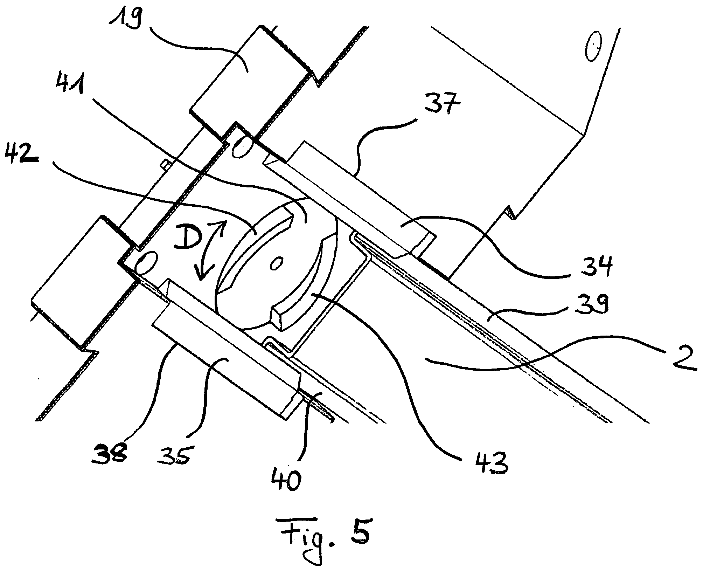

Der in den Fig. 4A, 4B und 5 zur besseren Veranschaulichung nochmals näher dargestellte Verriegelungsmechanismus umfasst zwei von zwei Federn 32, 33 in eine Verriegelungsposition vorgespannte Haltebacken 34, 35 und eine zwischen den Haltebacken 34, 35 angeordnete Exzenterscheibe 36, welche mit dem als Drehknopf ausgestalteten Bedienkörper 17 gekoppelt ist. In der in den Fig. 4A und 5 dargestellten Stellung der Exzenterscheibe 36 reichen die Haltebacken 34, 35 durch hierfür vorgesehene Aussparungen 37, 38 der Gehäuseschale 19 hindurch und hintergreifen die seitlichen Berandungen 39, 40 der Hutschiene 2, so dass der Grundkörper 3a fest an der Hutschiene 2 montiert ist. Wird nun der als Drehknopf ausgestaltete Bedienkörper 17 in einer Drehrichtung gemäß Doppelpfeil D verdreht, so spreizt die Exzenterscheibe 36 sukzessive die Haltebacken 34, 35 auseinander, bis der Grundkörper 3a von der Hutschiene 2 abgenommen werden kann.

Ferner ist mit dem Bedienkörper 17 auch eine gehäuseunterseitig angeordnete Anhebescheibe 41 gekoppelt, an deren zur Hutschiene 2 weisenden Seite zwei sich über einen gewissen Winkelbereich der Anhebescheibe erstreckende Aufsätze 42, 43 mit in Drehrichtung zunehmender Höhe angeordnet sind. Diese Aufsätze 42, 43 stützen sich bei zunehmender Drehung des Drehknopfs 17 an je einem Rand 40, 39 der Hutschiene 2 ab (vgl. Fig. 5) und bewirken mit fortschreitender Drehung eine exakt vertikal erfolgende Anhebung des Grundkörpers 3a von der Hutschiene 2, womit gleichzeitig die Verbindung zu den Verbindungselementen 7a, 7b benachbarter Grundkörper getrennt wird.
Der Drehknopf 17 ist bei zusammengebautem Grundkörper 3a oberhalb der Leiterplatte 20 angeordnet und greift mit seinem - mit der Exzenterscheibe 36 gekoppelten - Achszapfen durch eine entsprechende Aussparung A (vgl. Fig. 3) in der Leiterplatte 20 hindurch. Die Drehbarkeit des Drehknopfs 17 ist durch einen in der unteren Gehäuseschale 19 des Grundkörpers 3a vorgesehenen Anschlag 64 begrenzt.

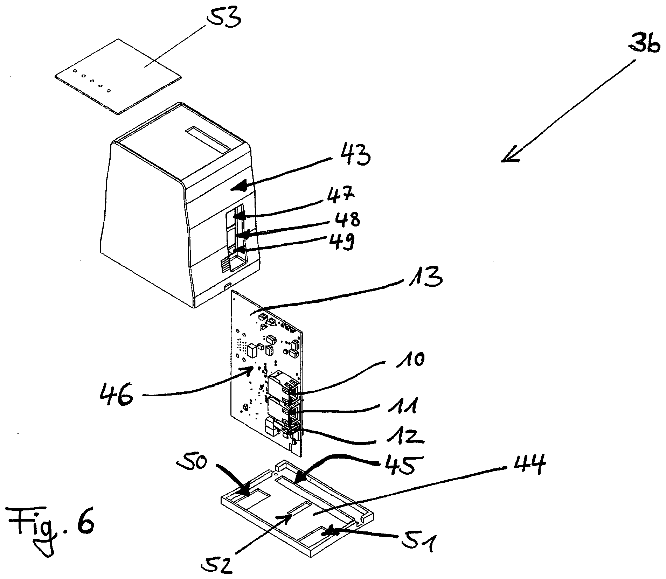

Fig. 6 zeigt eine Explosionsdarstellung eines Aufsatzkörpers 3b eines im Rahmen der Erfindung verwendbaren Steuerungsmoduls. Dieser umfasst zwei Gehäuseschalen 43, 44, wobei die den Aufsatzkörper 3b zum Grundkörper 3a begrenzende Gehäuseschale 44 eine spaltförmige Aussparung 45 aufweist, durch welche der die Steckverbindung zum Grundkörper 3a herstellende untere Rand der Leiterplatte 13 aus dem Aufsatzkörpergehäuse 43, 44 hervorstehen kann.
Die Leiterplatte 13, welche fest in der oberen Gehäuseschale 43 montiert wird, trägt die Steuerungselektronik 46 des Steuerungsmoduls sowie die - durch die obere Gehäuseschale 43 durch entsprechende Aussparungen 47, 48, 49 zugänglichen - Datenkommunikationsschnittstellen 10, 11, 12.

Weitere Aussparungen 50, 51, 52 in der unteren Gehäuseschale 44 des Aufsatzkörper nehmen den in Richtung Aufsatzkörper hervorstehenden Rand der grundkörperseitig angeordneten Relais 26, 27 und des Bedienkörpers 17 auf. Eine Folie 53 dient zur einfachen Anbringung einer Beschriftung am Aufsatzkörper, und zwar auf der in der Regel die Frontseite des Steuerungsmoduls bildenden Seite.

Fig. 7 zeigt schließlich noch eine schematische Darstellung eines erfindungsgemäßen Systems, bei welchem insgesamt acht Grundkörper 3a, 4a, 5a, 54a, 55a, 56a, 57a, 58a verschiedener Steuerungsmodule unmittelbar benachbart - auf einer nicht dargestellten Hutschiene - montiert und über - ebenfalls nicht dargestellte Verbindungselemente - miteinander verbunden sind. Mit fünf der Grundkörper 3a, 4a, 5a, 55a, 58a sind jeweils die entsprechenden Aufsatzkörper 3b, 4b, 5b, 55b, 58b der betreffenden Steuerungsmodule verbunden, während von den übrigen Grundkörpern 54a, 56a, 57a der betreffende Aufsatzkörper gelöst und somit momentan nicht mit den betreffenden Grundkörpern verbunden ist.

Gut zu erkennen ist, dass die elektrische Stromversorgung 59 und das CAN-Bussystem 60 innerhalb der jeweiligen Grundkörper so verschalten ist, dass jedes aus Grundkörper und Aufsatzkörper bestehende Steuerungsmodul mit Strom versorgt wird und an das Bussystem angebunden ist, obwohl vorliegend bei insgesamt drei Steuerungsmodulen der jeweilige Aufsatzkörper von dem betreffenden Grundkörper getrennt (und somit nicht dargestellt) ist. Der besseren Übersichtlichkeit halber wurde hierbei die Verschaltung der Stromversorgung und des Bussystems mit einer einzigen Linie dargestellt, obwohl hierfür ersichtlich jeweils eine zweipolige Verbindung erforderlich ist.

Fig. 7 zeigt darüber hinaus, dass in die Grundkörper 4a, 5a, 54a, 55a, 56a, 57a, 58a der rechts neben dem Hauptsteuerungsmodul 3a, 3b angeordneten Steuerungsmodule separate Schaltkreise 63 integriert sind, welche von zwei Signalleitungen 61, 62 des Hauptsteuerungsmoduls 3 angesteuert werden und welche über geeignete Verbindungselemente untereinander und mit der Steuerelektronik des jeweiligen Steuerungsmoduls verbunden sind. Die Verbindung dieser - je einen Flip-Flop beinhaltenden - Schaltkreise 63 der verschiedenen Grundkörper erfordert eine 2-polige Verbindung, die vorliegend über die bereits weiter oben beschriebenen Verbindungselemente 7a, 7b hergestellt wird. Die Verbindung der Schaltkreise 63 mit der jeweiligen Steuerungselektronik 46 des betreffenden Steuerungsmoduls erfolgt über die bereits erläuterte (Leiterplatten-)Steckverbindung zwischen Grund- und Aufsatzkörper.

Jeder Flip-Flop der Schaltkreise 63 erfüllt die Funktion, dass an dessen rechtsseitigem Ausgang ein aktiver Pegel erzeugt wird, wenn zum Zeitpunkt eines Pegelwechsel auf der Taktsignalseite (LOC-CLK) gleichzeitig ein aktives Signal auf der Signalseite (LOC-ACT) anliegt.

Die Signalleitung 62 dient dabei zur Aussendung eines mit LOC-CLK bezeichneten Taktsignals in Art von Zählimpulsen, welche als Zähler für die Einbauposition der betreffenden Steuerungsmodule fungieren und welche - nach Erreichen der maximalen Anzahl von an das System anschließbaren Steuerungsmodulen - zyklisch wiederholt werden. Die Wartezeit zwischen zwei Zählimpulsen entspricht dabei derjenigen Zeit, die einem Steuerungsmodul zur Antwort auf ein entsprechendes Eingangssignal zugestanden wird.

Die Signalleitung 61 dient zur Aussendung eines Datenbits "LOC-ACT", welches so mit dem ersten Zählimpuls "LOC-CLK" der Signalleitung 62 zu synchronisieren ist, dass am Ausgang des Flip-Flops des ersten auf das Hauptsteuerungsmodul 3a, 3b folgenden Steuerungsmoduls 4a, 4b ein aktiver Pegel erzeugt wird. Dieser aktive Pegel wird der im Aufsatzkörper 4b angeordneten Steuerungselektronik 46 zugeführt, welche so programmiert ist, dass sie bei Eingang des aktiven Pegels an dem betreffenden Eingang ein das Steuerungsmodul (und dessen Funktionalität/Bauart) identifizierendes Identifikationssignal über den CAN-Bus 60 an das Hauptsteuerungsmodul 3a, 3b zurücksendet, wo nun erkennbar ist, dass das betreffende Steuerungsmodul 4a, 4b an der ersten Einbauposition hinter dem Hauptsteuerungsmodul 3a, 3b verbaut ist.

Mit Versand des nächsten Zählimpulses LOC-CLK über die Taktsignalleitung 62, wird nun im zweiten auf das Hauptesteuerungsmodul 3a, 3b folgenden Steuerungsmodul 5a, 5b ein aktiver Pegel am Ausgang des dortigen Flip-Flops erzeugt und gleichzeitig der aktive Pegel am Ausgang des Flip-Flops im ersten auf das Hauptsteuerungsmodul 3a, 3b folgenden Steuerungsmodul 4a, 4b zurück auf Null gesetzt, so dass nun lediglich an dem zweiten - auf das Hauptsteuerungsmodul 3a, 3b folgenden - Steuerungsmodul 5a, 5b ein aktiver Pegel anliegt, der wiederum eine entsprechende Antwort des Steuerungsmoduls 5a, 5b über den CAN-Bus 60 auslöst, so dass nun auch die Identität des zweiten auf das Hauptsteuerungsmodul folgenden Steuerungsmoduls ermittelt ist.

Mit jedem Zählimpuls LOC-CLK wird somit - in Art eines Schieberegisters - die nächstfolgende Einbauposition im Hinblick auf die Existenz eines weiteren Moduls abgefragt, wobei vorliegend beim dritten, fünften und sechsten Zählimpuls - wegen der dort nicht am jeweiligen Grundkörper 54a, 56a, 57a angeschlossenen Aufsatzkörper - keine Rückantwort erfolgt, so dass das System erkennt, dass an den betreffenden Einbaupositionen derzeit kein einen Aufsatzkörper aufweisendes Steuerungsmodul installiert ist. Demgegenüber ist beim vierten und siebten Zählimpuls mit einer Antwort des betreffenden Steuerungsmoduls 55a, 55b bzw. 58a, 58b zu rechnen.

Nachdem auf diese Weise die vorgebbare Maximalzahl an möglichen Einbaupositionen abgefragt wurde, kann die vorstehende Abfrageroutine unter erneuter Aussendung eines geeignet mit dem (neuen) ersten Zählimpuls LOC-CLK synchronisierten Datenbits (LOC-ACT) beginnen, so dass erkennbar wird, wenn ein Steuerungsmodul nach Aufstecken des betreffenden Aufsatzkörpers wieder einsatzbereit ist. Ferner kann so die exakte Einbauposition aller am System angeschlossenen Steuerungsmodule relativ zum Hauptsteuerungsmodul ermittelt werden.

## Patentansprüche

1. Modulares Steuerungssystem (1), nämlich speicherprogrammierbare Steuerung, umfassend eine Mehrzahl an zum Anbau an eine Tragschiene (2), insbesondere eine Hutschiene, geeigneten Steuerungsmodulen (3, 4, 5),
wobei die Steuerungsmodule (3,4,5) über ein Bussystem (60) miteinander verbunden sind und Anschlusselemente (6) zum Anschluss externer Feldelemente aufweisen,
wobei die Steuerungsmodule (3, 4, 5) jeweils einen an der Tragschiene (2) montierbaren Grundkörper (3a, 4a, 5a) sowie einen lösbar an dem Grundkörper (3a, 4a, 5a) montierten Aufsatzkörper (3b, 4b, 5b) aufweisen,
wobei der Grundkörper (3a, 4a, 5a) jedes Steuerungsmoduls (3, 4, 5) einen Anschluss (8) für die Stromversorgung (59) des Steuerungsmoduls (3, 4, 5), wenigstens einen Bussystemanschluss (9) zur Anbindung des Steuerungsmoduls (3, 4, 5) an das Bussystem (60) und wenigstens ein Anschlusselement (6) für ein Feldelement aufweist und
wobei der Aufsatzkörper (3b, 4b, 5b) jedes Steuerungsmoduls (3, 4, 5) die Steuerungselektronik (46) des jeweiligen Steuerungsmoduls (3, 4, 5) aufweist,
**dadurch gekennzeichnet,**
**dass** der Grundkörper (3a, 4a, 5a) jedes Steuerungsmoduls (3, 4, 5) einen Magnetschalter (30) und ein Magnetelement (31) aufweist, die derart angeordnet sind, dass der Magnetschalter (30) eines ersten Steuerungsmoduls (3, 4, 5) mit dem Magnetelement (31) eines benachbart an der Tragschiene (2) montierten Steuerungsmoduls (3, 4, 5) zusammenwirkt,
wobei der Magnetschalter (30) im Falle der Abwesenheit eines Grundkörpers (3a, 4a, 5a) eines benachbarten Steuerungsmoduls (3, 4, 5) das Bussystem (60) durch Zuschaltung wenigstens eines Abschlusswiderstands terminiert und im Falle der Anwesenheit eines Grundkörpers (3a, 4a, 5a) eines benachbarten Steuerungsmoduls (3, 4, 5) eine Anbindung des benachbarten Steuerungsmoduls (3, 4, 5) an das Bussystem (60) zulässt.

2. Modulares Steuerungssystem nach Anspruch 1,
**dadurch gekennzeichnet,**
**dass** die Steuerungsmodule (3, 4, 5) zur einander unmittelbar benachbarten Montage an der Tragschiene (2) eingerichtet sind, wobei ausschließlich ein erstes Steuerungsmodul (3) (Hauptsteuerungsmodul) direkt mit der externen Stromversorgung (59) zu verbinden ist und wobei alle Steuerungsmodule (3) mittels geeignet zueinander korrespondierender Verbindungselemente (7a, 7b), die an den Grundkörpern (3a, 4a, 5a) der jeweiligen Steuerungsmodule (3, 4, 5) angeordnet sind, direkt mit dem wenigstens einen ihm unmittelbar benachbarten Steuerungsmodul (3, 4, 5) derart verbunden sind, dass über die Verbindungselemente (7a, 7b) die Anbindung aller Steuerungsmodule (3, 4, 5) an die Stromversorgung und das Bussystem erfolgt.

3. Modulares Steuerungssystem nach Anspruch 1 oder 2, **dadurch gekennzeichnet,**
**dass** der Aufsatzkörper (3b, 4b, 5b) jedes Steuerungsmoduls (3, 4, 5) mittels einer Steckverbindung am Grundkörper (3a, 4a, 5a) befestigt ist.

4. Modulares Steuerungssystem nach Anspruch 2 oder 3, **dadurch gekennzeichnet,**
**dass** die Verbindungselemente (7a, 7b) derart ausgestaltet sind, dass sich deren Verbindung durch eine vertikal zur Tragschiene (2) verlaufende Bewegung herstellen und trennen lässt, so dass ein beliebiges Steuerungsmodul (3, 4, 5) des Steuerungssystems (1) ausgetauscht werden kann, ohne dass dabei eines der übrigen Steuerungsmodule (3, 4, 5) ausgebaut oder verschoben werden muss.

5. Modulares Steuerungssystem nach einem der vorangehenden Ansprüche,
**dadurch gekennzeichnet,**
**dass** die Anbindung der Steuerungsmodule (3, 4, 5) an die externe Stromversorgung (59) und das Bussystem (60) derart grundkörperseitig erfolgt, dass ein Aufsatzkörper (4b, 5b) eines beliebigen nicht das Hauptsteuerungsmodul (3) darstellenden Steuerungsmoduls (4, 5) ausgetauscht werden kann, ohne die Kommunikation der übrigen Steuerungsmodule (3, 4, 5) über das Bussystem (60) und deren Stromversorgung (59) zu unterbrechen.

6. Modulares Steuerungssystem nach einem der vorangehenden Ansprüche,
**dadurch gekennzeichnet,**
**dass** der Grundkörper (3a, 4a, 5a) jedes Steuerungsmoduls einen Verriegelungsmechanismus zur stabilen Befestigung des Grundkörpers (3a, 4a, 5a) an der Tragschiene (2) aufweist, wobei der Verriegelungsmechanismus einen Bedienkörper (17) aufweist, bei dessen Betätigung die Verriegelung des Grundkörpers (3a, 4a, 5a) an der Tragschiene (2) gelöst und gleichzeitig der Grundkörper (2) senkrecht zur Tragschiene (2) von dieser angehoben wird.

7. Modulares Steuerungssystem nach Anspruch 6,
**dadurch gekennzeichnet,**
**dass** der Bedienkörper (17) ein Drehknopf ist und der Verriegelungsmechanismus eine mit dem Drehknopf gekoppelte Exzenterscheibe (36) aufweist, die zur Spreizung von Haltebacken (34, 35) des Verriegelungsmechanismus dient,
wobei ferner eine mit dem Drehknopf gekoppelte Anhebescheibe (41) vorgesehen ist, die an ihrer zur Tragschiene (2) weisenden Seite zwei sich über einen gewissen Winkelbereich der Anhebescheibe (41) erstreckende Aufsätze (42, 43) mit in Drehrichtung zunehmender Höhe aufweist, die sich bei Betätigung des Drehknopfs an einem Rand (39, 40) der Tragschiene (2) abstützen und mit fortschreitender Drehung ein vertikales Anheben des Grundkörpers (3a, 4a, 5a) von der Tragschiene (2) bewirken.

8. Modulares Steuerungssystem nach einem der vorangehenden Patentansprüche,
**dadurch gekennzeichnet,**
**dass** mittels separater und in die Grundkörper (4a, 5a) der jeweiligen Steuerungsmodule (4, 5) integrierter Schaltkreise (63), welche über geeignete Verbindungselemente (7a, 7b; 14) untereinander und mit der Steuerungselektronik (46) des jeweiligen Steuerungsmoduls (4, 5) verbunden sind, die exakte Einbauposition aller Steuerungsmodule (4, 5) relativ zu einem Hauptsteuerungsmodul (3) des Steuerungssystems (1) ermittelbar sind.

## Claims

1. A modular control system (1), namely a programmable logic controller, comprising a plurality of control modules (3, 4, 5) suitable for mounting on a mounting rail (2), in particular a cap rail,
wherein the control modules (3, 4, 5) are connected to one another via a bus system (60) and have connecting elements (6) for connecting external array elements,
wherein the control modules (3, 4, 5) each have a base body (3a, 4a, 5a) that can be mounted on the mounting rail (2) and a support body (3b, 4b, 5b) that is detachably mounted on the base body (3a, 4a, 5a),
wherein the base body (3a, 4a, 5a) of each control module (3, 4, 5) has a connection (8) for the power supply (59) of the control module (3, 4, 5), at least one bus system connection (9) for connecting the control module (3, 4, 5) to the bus system (60), and at least one connecting element (6) for an array element, and
wherein the support body (3b, 4b, 5b) of each control module (3, 4, 5) includes the control electronics (46) of the respective control module (3, 4, 5),
**characterized in**
**that** the base body (3a, 4a, 4b) of each control module (3, 4, 5) has a magnetic switch (30) and a magnetic element (31) which are arranged in such a manner that the magnetic switch (30) of a first control module (3, 4, 5) cooperates with the magnetic element (31) of a control module (3, 4, 5) adjacently mounted on the mounting rail (2),
wherein the magnetic switch (30), in the event of the absence of a base body (3a, 4a, 5a) of an adjacent control module (3, 4, 5), terminates the bus system (60) by connecting at least one terminating resistor, and in the event of the presence of a base body (3a, 4a, 5a) of an adjacent control module (3, 4, 5), allows a connection of the adjacent control module (3, 4, 5) to the bus system (60).

2. The modular control system according to claim 1,
**characterized in**
**that** the control modules (3, 4, 5) are configured for being mounted directly adjacent to one another on the mounting rail (2), wherein only a first control module (3) (main control module) is to be connected to the external power supply (59), and wherein all control modules (3) are directly connected to their at least one directly adjacent control module (3, 4, 5) by means of connection elements (7a, 7b) which are suitably corresponding to one another and are arranged on the base bodies (3a, 4a, 5a) of the respective control modules (3, 4, 5), in such a manner that the connection of all control modules (3, 4, 5) to the power supply and the bus system is carried out via the connection elements (7a, 7b).

3. The modular control system according to claim 1 or 3,
**characterized in**
**that** the support body (3b, 4b, 5b) of each control module (3, 4, 5) is fastened on the base body (3a, 4a, 5a) by means of a plug-in connection.

4. The modular control system according to claim 2 or 3
**characterized in**
**that** the connection elements (7a, 7b) are configured in such a manner that their connection can be established and disconnected by a movement running vertical to the mounting rail (2), so that any control module (3, 4, 5) of the control system (1) can be exchanged without having to disassemble or displace one of the remaining control modules (3, 4, 5).

5. The modular control system according to any one of the preceding claims,
**characterized in**
**that** the connection of the control modules (3, 4, 5) to the external power supply (59) and the bus system (60) is carried on the base body side in such a manner that a support body (4b, 5b) of any control module (4, 5) that does not constitute the main control module (3) can be exchanged without interrupting the communication of the remaining control modules (3, 4, 5) via the bus system (60) and their power supply (59).

6. The modular control system according to any one of the preceding claims,
**characterized in**
**that** the base body (3a, 4a, 5a) of each control module has a locking mechanism for stable fastening of the base body (3a, 4a, 5a) on the mounting rail (2), wherein the locking mechanism has an operating body (17), upon actuation of which the locking of the base body (3a, 4a, 5a) on the mounting rail (2) is released and the base body (2) is lifted at the same time from the mounting rail (2) in a direction perpendicular thereto.

7. The modular control system according to claim 6,
**characterized in**
**that** the operating body (17) is a rotary knob and the locking mechanism is an eccentric disc (36) which is coupled to the rotary knob and which serves for spreading apart holding jaws (34, 35) of the locking mechanism, wherein, furthermore, a lifting disc (41) is provided which is coupled to the rotary knob and which, on its side facing the mounting rail (2), has two attachments (42, 43) which extend over a certain angular range of the lifting disc (41) and increase in height in the rotation direction and which, upon actuation of the rotary knob, are supported on an edge (39, 40) of the mounting rail (2) and, with progressing rotation, effect a vertical lifting of the base body (3a, 4a, 5a) from the mounting rail (2).

8. The modular control system according to any one of the preceding claims,
**characterized in**
**that** by means of separate circuits (63), which are integrated in the base bodies (4a, 5a) of the respective control modules (4, 5) and which are connected to one another and to the control electronics (46) of the respective control module (4, 5) via suitable connection elements (7a, 7b; 14), the exact mounting position of all control modules (4, 5) relative to a main control module (3) of the control system (1) can be determined.

## Revendications

1. Système de commande modulaire (1), à savoir commande programmable par mémoire, comprenant une pluralité de modules de commande (3, 4, 5) aptes à être montés sur un rail porteur (2), en particulier un rail à chapeau,
dans lequel les modules de commande (3,4,5) sont connectés entre eux par un système de bus (60) et présentent des éléments de raccordement (6) pour le raccordement d'éléments de champ externes,
dans lequel les modules de commande (3, 4, 5) présentent respectivement un corps de base (3a, 4a, 5a) pouvant être monté sur le rail porteur (2) et un corps sommital (3b, 4b, 5b) monté de manière amovible sur le corps de base (3a, 4a, 5a),
dans lequel le corps de base (3a, 4a, 5a) de chaque module de commande (3, 4, 5) présente un raccord (8) pour l'alimentation électrique (59) du module de commande (3, 4, 5), au moins un raccord de système de bus (9) pour la connexion du module de commande (3, 4, 5) au système de bus (60) et au moins un élément de raccordement (6) pour un élément de champ et dans lequel le corps sommital (3b, 4b, 5b) de chaque module de commande (3, 4, 5) présente l'électronique de commande (46) du module de commande respectif (3, 4, 5),
**caractérisé en ce que**
le corps de base (3a, 4a, 5a) de chaque module de commande (3, 4, 5) présente un commutateur magnétique (30) et un élément magnétique (31) qui sont disposés de manière à ce que le commutateur magnétique (30) d'un premier module de commande (3, 4, 5) coopère avec l'élément magnétique (31) d'un module de commande (3, 4, 5) monté à proximité du rail porteur (2),
le commutateur magnétique (30), en cas d'absence d'un camp de base (3a, 4a, 5a) d'un module de commande voisin (3, 4, 5), coupant le système de bus (60) en mettant en circuit au moins une résistance terminale et, dans le cas de la présence d'un corps de base (3a, 4a, 5a) d'un module de commande voisin (3, 4, 5), permettant une connexion du module de commande voisin (3, 4, 5) au système de bus (60).

2. Système de commande modulaire selon la revendication 1, **caractérisé en ce que**
les modules de commande (3, 4, 5) sont conçus pour un montage mutuellement directement adjacent sur le rail porteur (2), exclusivement un premier module de commande (3) (module de commande principal) devant être connecté directement à l'alimentation électrique externe (59) et tous les modules de commande (3) étant connectés directement au moyen d'éléments de connexion (7a, 7b) se correspondant entre eux de manière appropriée et qui sont disposés au niveau des corps de base (3a, 4a, 5a) des modules de commande respectifs (3, 4, 5) à l'au moins un module de commande directement adjacent (3, 4, 5) de manière à ce que la connexion de tous les modules de commande (3, 4, 5) à l'alimentation électrique et au système de bus soit établie par les éléments de connexion (7a, 7b).

3. Système de commande modulaire selon la revendication 1 ou 2,
**caractérisé en ce que**
le corps sommital (3b, 4b, 5b) de chaque module de commande (3, 4, 5) est fixé au moyen d'un raccord enfichable au corps de base (3a, 4a, 5a).

4. Système de commande modulaire selon la revendication 2 ou 3,
**caractérisé en ce que**
les éléments de connexion (7a, 7b) sont conçus de manière à ce que leur connexion soit établie et dissociée par un mouvement orienté verticalement par rapport au rail porteur (2), de sorte que tout module de commande (3, 4, 5) du système de commande (1) peut être échangé sans devoir pour ce faire démonter ou décaler un des modules de commande restants (3, 4, 5).

5. Système de commande modulaire selon une des revendications précédentes,
**caractérisé en ce que**
la connexion des modules de commande (3, 4, 5) à l'alimentation électrique externe (59) et au système de bus (60) est établie au niveau du corps de base de manière à ce qu'un corps sommital (4b, 5b) de n'importe quel module de commande (4, 5) ne constituant pas le module de commande principal (3) puisse être échangé sans interrompre la communication des modules de commande restants (3, 4, 5) par l'intermédiaire du système de bus (60) et de son alimentation électrique (59).

6. Système de commande modulaire selon une des revendications précédentes,
**caractérisé en ce que**
le corps de base (3a, 4a, 5a) de chaque module de commande présente un mécanisme de verrouillage pour la fixation stable du corps de base (3a, 4a, 5a) au rail porteur (2), le mécanisme de verrouillage présentant un corps de manoeuvre (17) à l'actionnement duquel le verrouillage du corps de base (3a, 4a, 5a) au rail porteur est suspendu (2) et le corps de base est en même temps soulevé perpendiculairement au rail porteur (2) de celui-ci.

7. Système de commande modulaire selon la revendication 6, **caractérisé en ce que**
le corps de manoeuvré (17) est un bouton rotatif et que le mécanisme de verrouillage présente un disque excentrique (36) couplé au bouton rotatif et qui sert à écarter des mâchoires de retenue (34, 35) du mécanisme de verrouillage,
étant en outre prévu un disque de relevage (41) couplé au bouton rotatif qui présente, sur sa face tournée vers le rail porteur (2), deux chapeaux (42, 43) s'étendant sur une certaine zone angulaire du disque de relevage (41) et dont la hauteur augmente dans le sens de rotation et qui, en cas d'actionnement du bouton rotatif, s'appuient sur un bord (39, 40) du rail porteur (2) et au fur et à mesure que la rotation progresse, provoquent un soulèvement vertical du corps de base (3a, 4a, 5a) du rail porteur (2).

8. Système de commande modulaire selon une des revendications précédentes,
**caractérisé en ce que**
au moyen de circuits de commutation séparés (63) et intégrés dans les corps de base (4a, 5a) des modules de commande respectifs (4, 5) et qui sont raccordés entre eux et à l'électronique de commande (46) par des éléments de raccordement appropriés (7a, 7b; 14) du module de commande respectif (4, 5), la position exacte de montage tous les éléments de commande par rapport à un module de commande principal (3) du système de commande (1) peut être déterminée.
